# EUROPEAN PATENT SPECIFICATION

(11) **EP 0 495 576 B1**
(45) Date of publication and mention of the grant of the patent: **26.04.1995**
(21) Application number: 92300111.9
(22) Date of filing: 07.01.1992
(51) Int. Cl.: H01S 3/096, H01S 3/103, G11B 7/125

(54) **laser driver for an optical disk drive**
Lasertreiber zur Verwendung in einem optischen Plattenlaufwerk
Dispositif de commande d'un laser utilisé dans un entraînement de disque optique

(30) Priority: 17.01.1991 JP 44574/91
(43) Date of publication of application: 22.07.1992
(73) Proprietor: International Business Machines Corporation, Armonk, N.Y. 10504 (US)
(72) Inventor: Amano, Yoshiro, Seya-ku, Yokohama-shi, Kanagawa-ken (JP); Hokozono, Kazuo, Fujisawa-shi, Kanagawa-ken (JP); Shimofusa, Tatsuo, Yamato-shi, Kanagawa-ken (JP)
(74) Representative: Burt, Roger James, Dr.

(56) References cited:
- EP-A- 0 169 579
- GB-A- 2 183 896
- PATENT ABSTRACTS OF JAPAN vol. 13, no. 114 (E-730)20 March 1989 & JP-A-63 285 990
- PATENT ABSTRACTS OF JAPAN vol. 13, no. 155 (E-743)14 April 1989 & JP-A-63 312 687
- IBM TECHNICAL DISCLOSURE BULLETIN. vol. 30, no. 1, June 1987, NEW YORK US pages356 - 357; 'Lasediode control circuits'

## Description

The present invention relates to a laser driver for an optical disk drive.

In a laser driver, it is desirable to ground either the anode or the cathode of the laser to suppress surge current. Moreover, to drive the laser, it is advisable to connect the laser to the collector of a transistor switch for turning on or off a current to the laser. Conventional laser drivers use either a sink (inflow) current supply or a source (outflow) current supply.

In a conventional laser driver in which only a sink current supply is used, a negative voltage source must be provided in addition to a positive voltage source. However, in a conventional laser driver in which only a source current supply is used, the negative voltage source is not required, but PNP transistor switches must be used. PNP transistors are generally slow in switching operations and hence mitigate against increasing the switching speed of the laser.

The present invention is defined in independent claims 1 and 5. Embodiments are set out in the dependent claims.

In accordance with claim 1 of the present invention, there is now provided a laser driver comprising a source current supply for supplying a constant source current Ia, a sink current supply for supplying a constant sink current Ib, and a switching circuit for selectively forming, in response to an input signal, either of a current path through which the constant source current Ia from said source current supply flows into said laser and a current path through which at least a part of said constant source current Ia from said source current supply flows into said sink current supply.

This advantageously permits higher speed switching of the laser without requiring two voltage sources.

In a preferred embodiment of the present invention, there is provided both a source current supply and a sink current supply and a switching means for selectively forming either a current path through which a constant source current from the source current supply flows into a laser to turn the laser on or a current path through which at least a part of the constant source current from the source current supply flows into the sink current supply to turn the laser off wherein the switching means comprises NPN transistors to avoid the need for a negative voltage source.

A preferred embodiment of the present invention will now be described with reference to the accompanying drawings in which:

FIG.1 is a circuit diagram of a laser driver in accordance with the present invention.

FIG.2 is a timing diagram indicating current signals in each part of the laser driver of the present invention.

FIG.3 is a circuit diagram of an example of a conventional laser driver.

FIG.4 is a circuit diagram of another example of the conventional laser driver.

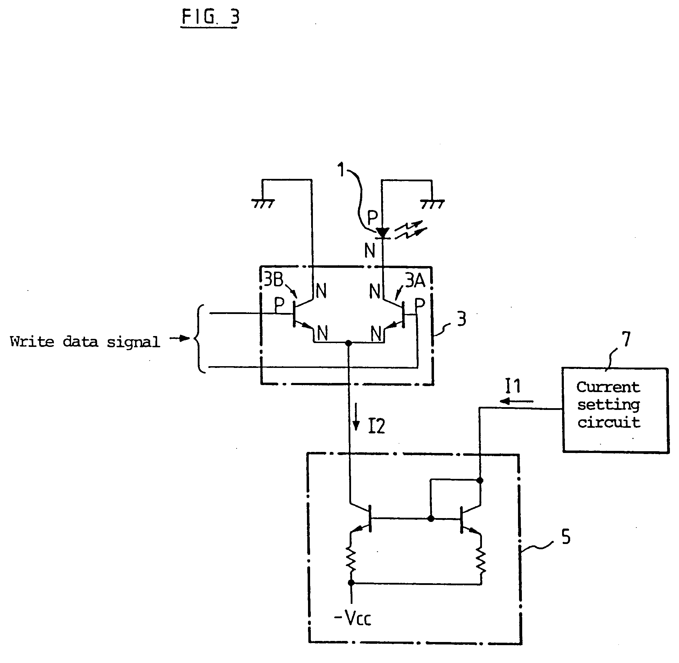

Referring first to Figure 3, in an example of a conventional laser drive in which only a sink current supply is used, one terminal of a laser 1 is grounded and the other terminal is connected to the collector of one transistor 3A of a differential current switching circuit 3 comprising a pair of NPN transistors 3A and 3B. The collector of the other transistor 3B is grounded. To operate the laser driver in an optical disk drive, write data signals are alternately applied inversely to the bases of the transistors 3A and 3B. The emitters of the transistors 3A and 3B are coupled to each other and connected to a sink current supply 5. The sink current supply 5 is in the form of a current mirror circuit and receives a constant (sink) current I2 as a function of a (setting) current I1 from a current setting circuit 7. It is necessary to provide a negative source voltage -Vcc to the sink current supply 5. A negative voltage source -Vcc must therefore be provided in addition to a positive voltage source for driving the laser.

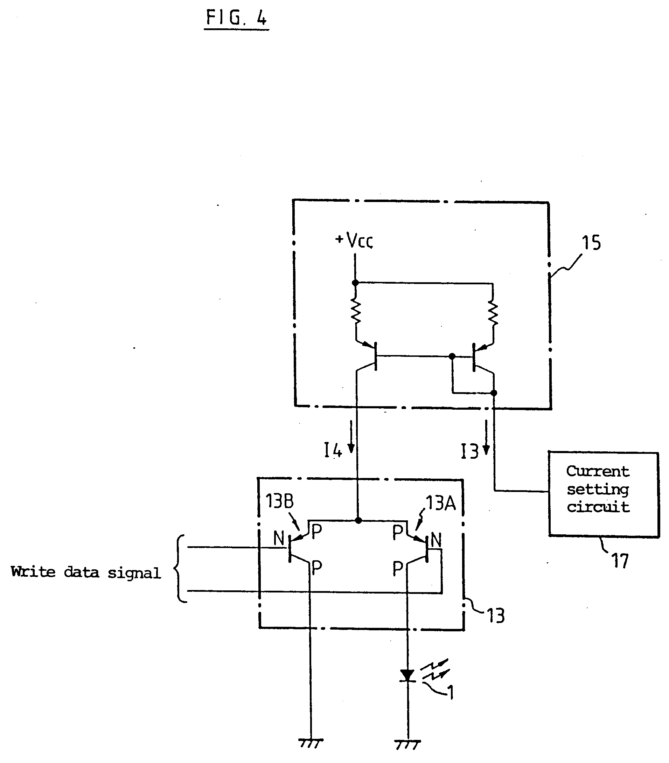

Referring now to Figure 4, in an example of a conventional laser driver in which only a source current supply is used, one terminal of the laser 1 is grounded and the other terminal is connected to the collector of one transistor 13A of a differential current switching circuit 13 comprising a pair of PNP transistors 13A and 13B. The collector of the other transistor 13B is grounded. To operate the laser driver in an optical disk drive, write data signals are alternately applied inversely to the bases of the transistors 13A and 13B. The emitters of the transistors 13A and 13B are connected to each other and to a source current supply 15. The source current supply 15 in the form of a current mirror circuit and provides a constant (source) current 14 as a function of a setting current I3 from a current setting circuit 17. A negative voltage source -Vcc is not needed, but PNP transistors must be used as switching elements. However, PNP transistors are generally slow in switching operations thereby limiting the switching speed of the laser.

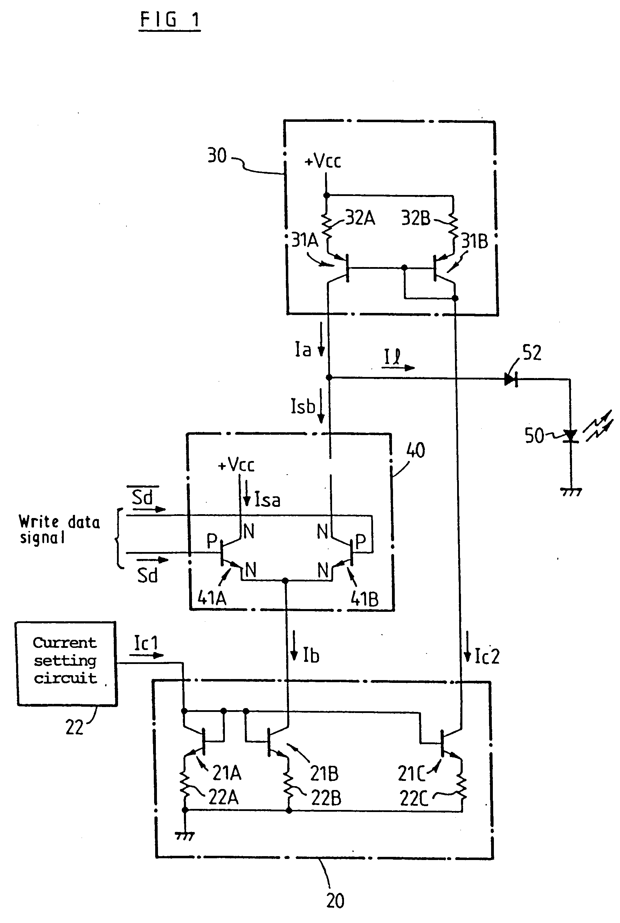

Referring now to Figure 1 in a laser driver of the present invention, a sink current supply 20 is provided by a current mirror circuit comprising NPN transistors 21A, 21B, and 21C and resistances 22A, 22B, and 22C. Setting current Ic1 flows into transistor 21A. The base and collector of transistor 21A, the base of transistor 21B, and the base of transistor 21C are connected to one another. Thus, the collector voltage of transistor 21A is applied to the base of transistor 21B and the base of transistor 21C. The emitters of transistors 21A, 21B, and 21C are grounded through resistances 22A, 22B, and 22C, respectively. In operation, the currents flowing through transistors 21B and 21C are determined by the setting current Ic1. The current flowing through transistor 21B is a sink current Ib flowing from the sink current supply. The current flowing through transistor 21C is the setting current Ic2 flowing from a source current supply 30.

The source current supply 30 is provided by a current mirror circuit comprising PNP transistors 31A and 31B and resistances 32A and 32B. Thus, respective bases of transistors 31A and 31B are supplied with setting current Ic2 from the sink current supply 20. The respective emitters of transistors 31A and 31B are connected to a positive voltage source +Vcc through resistances 32A and 32B. In use, the setting current Ic2 determines a source current Ia flowing through transistor 31A.

The source current Ia from the source current supply 30 is separated into two paths. One path is connected to a differential switching circuit 40 and the other path is connected to a laser 50 through a diode 52 for preventing a back current. The current flowing from the source current supply 30 into the switching circuit 40 and the current flowing from the source current supply 30 into the laser 50 will hereinafter be referred to as switching current Isb and laser current Il, respectively. The switching circuit 40 includes a pair of NPN transistors 41A and 41B. A write data signal Sd is applied to the base of the transistor 41A, and an inverted write data signal Sd is applied to the base of the transistor 41B. The collector of transistor 41B is connected to the source current supply 30 and the laser 50, the collector of transistor 41A is connected to a positive voltage source +Vcc. Thus, when transistor 41A is on, a switching current Isa flows into the transistor 41A. When transistor 41B is on, the switching current Isb flows into transistor 41B. The emitters of transistors 41A and 41B are coupled to each other and connected to the sink current supply 20. The sink current supply 20 and the source current supply 30 are configured in such a manner that the source current Ia and the sink current Ib are the same.

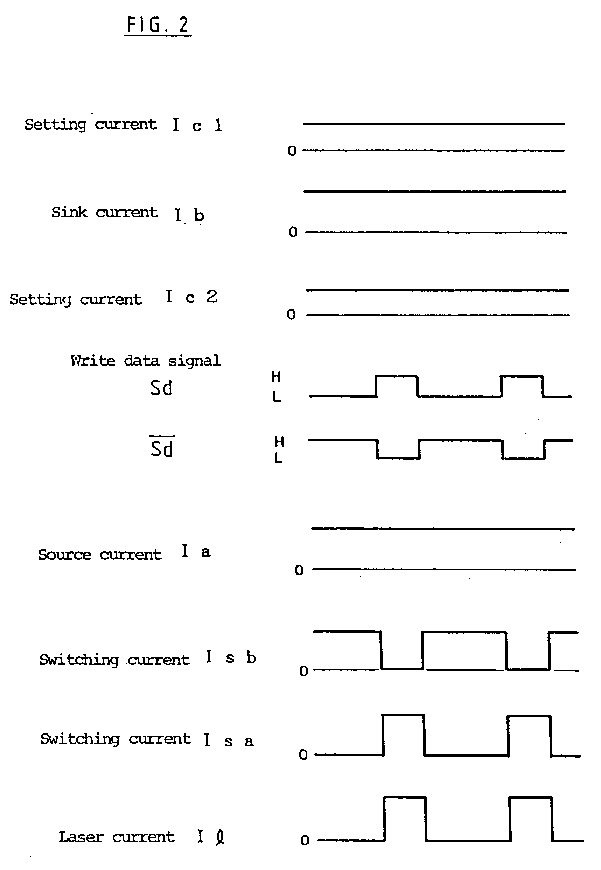

Referring now to Figure 2, in operation, the setting current Ic1 from a current setting circuit 22 determines a sink current Ib of the sink current supply 20 and a setting current Ic2 for the source current supply 30 and the setting current Ic2 determines the source current Ia of the source current supply 30. As described above, the source current Ia and the sink current Ib are the same. The write data signal Sd and its inversion Sd are applied to the bases of the transistors 41A and 41B, respectively. Thus, when the transistors 41A and 41B are turned on and off, respectively, the switching current Isa flowing through transistor 41A becomes sink current Ib. The switching current Isb flowing into transistor 41B becomes zero. A laser current Il therefore becomes source current Ia and the laser 50 turns on. When the transistors 41A and 41B are turned off and on, respectively, switching current Isa flowing into transistor 41A becomes zero. Switching current Isb flowing through transistor 41B becomes sink current Ib, that is, source current Ia. The laser current Il therefore becomes zero and the laser 50 turns off.

Thus one terminal of the laser 50 is grounded and transistor 41B, acting as the switch is connected to the laser 50 in a collector follower arrangement. Therefore transistor 41B can be an NPN transistor with a high switching speed. Therefore the circuit advantageously permits high-speed switching operations in typically several nanoseconds. Further, the laser driver can operate without the need of any negative voltage source.

In the embodiment of the present invention hereinbefore described, the source current Ia is equal to that of the sink current Ib. However, this is not always necessary. It will be appreciated that part of the source current Ia can pass to the sink current supply to decrease the current flowing into the laser for switching the laser. In the embodiment of the present invention hereinbefore described, circuits are so constructed that the setting current Ic2 to the sink current supply 20 controls the source current Ia from the source current supply 30 and the source current is equal to the sink current Ib. However, it will be appreciated that other circuits can be constructed to maintain the source current Ia equal to the sink current Ib. It will be appreciated also that the sink current supply 20 and the source current supply 30 may be formed in a circuit other than a current mirror. It will be appreciated also that the switching means may be of a non-differential type. It will be appreciated that the present invention can be applied to devices other than optical disk drives such as, for example, optical communication apparatus, laser printers and the like.

It will now be appreciated that the present invention permits higher speed switching of the laser without requiring two voltage sources.

## Claims

1. A laser driver comprising a source current supply (30) for supplying a constant source current Ia, a sink current supply (20) for supplying a constant sink current Ib, and a switching circuit (40) for selectively forming, in response to an input signal, either of a current path through which the constant source current Ia from the source current supply (30) flows into a laser (50) connected to the laser driver and a current path through which at least a part of the constant source current Ia from the source current supply (30) flows into the sink current supply (20).

2. The laser driver as claimed in claim 1 wherein the constant source current Ia and the constant sink current Ib are equal to each other and the switching circuit (40) is constructed in such a manner that either a current path through which all of the constant current Ia from the source current supply (30) flows into the laser (50) or a current path through which all of the constant current Ia from the source current supply (30) flows into the sink current supply (20) is selectively formed

3. The laser driver as claimed in claim 1 or claim 2 wherein the switching circuit (40) is a differential switching circuit having a pair of NPN transistors connected in a long-tail pair configuration.

4. The laser driver as claimed in any one of the preceding claims wherein both the source current supply (30) and the sink current supply (20) comprise a current mirror circuit.

5. An optical disk drive comprising a laser (50) for irradiating a laser beam onto an optical disk, a source current supply (30) for supplying a constant current Ia, a sink current supply (20) for receiving a constant current Ib, and a switch circuit (40) for selectively forming in response to a write signal either a current path through which a constant current Ia from the source current supply (30) mainly flows into the laser (50) or a current path through which the constant current Ia from the source current supply (30) mainly flows into the sink current supply (20).

## Patentansprüche

1. Lasertreiber, mit einer Stromquellenversorgung (30) zum Einspeisen eines Konstantquellenstroms Ia, einer Stromsenkenversorgung (20) zum Einspeisen eines Konstantsenkenstroms Ib und einer Verknüpfungsschaltung (40) zum selektiven Bilden, in Reaktion auf ein Eingangssignal, entweder eines Strompfades, durch welchen der Konstantquellenstrom Ia von der Stromquellenversorgung (30) in einen Laser (50), der mit dem Lasertreiber verbunden ist, fließt, oder eines Strompfades, durch welchen mindestens ein Teil des Konstantquellenstroms Ia von der Stromquellenversorgung (30) in die Stromsenkenversorgung (20) fließt.

2. Lasertreiber nach Anspruch 1, wobei der Konstantquellenstrom Ia und der Konstantsenkenstrom Ib untereinander gleich sind und die Verknüpfungsschaltung (40) in einer derartigen Weise gebaut ist, daß entweder ein Strompfad, durch welchen der gesamte Konstantstrom Ia von der Stromquellenversorgung (30) in den Laser (50) fließt, oder ein Strompfad, durch welchen der gesamte Konstantstrom Ia von der Stromquellenversorgung (30) in die Stromsenkenversorgung (20) fließt, selektiv gebildet wird.

3. Lasertreiber nach Anspruch 1 oder 2, wobei die Verknüpfungsschaltung (40) eine differentielle Verknüpfungsschaltung ist, die ein NPN-Transistorpaar, das in einer Differenzverstärkeranordnung verbunden ist, aufweist.

4. Lasertreiber nach irgendeinem der vorhergehenden Ansprüche, wobei sowohl die Stromquellenversorgung (30) als auch die Stromsenkenversorgung (20) eine Stromspiegelschaltung umfassen.

5. Optisches Plattenlaufwerk mit einem Laser (50) zum Ausstrahlen eines Laserstrahls auf eine optische Platte, einer Stromquellenversorgung (30) zum Einspeisen eines Konstantstroms Ia, einer Stromsenkenversorgung (20) zum Empfangen eines Konstantstroms Ib und einer Verknüpfungsschaltung (40) zum selektiven Bilden, in Reaktion auf ein Schreibsignal, entweder eines Strompfades, durch welchen ein Konstantstrom Ia von der Stromquellenversorgung (30) hauptsächlich in den Laser (50) fließt, oder eines Strompfades, durch welchen mindestens der Konstantstrom Ia von der Stromquellenversorgung (30) hauptsächlich in die Stromsenkenversorgung (20) fließt.

## Revendications

1. Dispositif de commande d'un laser comprenant une alimentation génératrice de courant (30) pour délivrer un courant de source constant Ia, une alimentation réceptrice de courant (20) pour recevoir un courant de réception constant Ib et un circuit de commutation (40) pour former sélectivement en réponse à un signal d'entrée soit un trajet de courant à travers lequel le courant de source constant Ia provenant de l'alimentation génératrice de courant (30) circule dans un laser (50) relié au dispositif de commande du laser, soit un trajet de courant à travers lequel au moins une partie du courant de source constant Ia provenant de l'alimentation génératrice de courant (30) circule dans l'alimentation réceptrice de courant (20).

2. Dispositif de commande d'un laser selon la revendication 1, dans lequel le courant de source constant Ia et le courant récepteur constant Ib sont égaux l'un à l'autre et le circuit de commutation (40) est construit de manière telle que soit un trajet de courant par l'intermédiaire duquel la totalité du courant constant Ia provenant de l'alimentation génératrice de courant (30) circule dans le laser (50), soit un trajet de courant par l'intermédiaire duquel la totalité du courant constant Ia provenant de l'alimentation génératrice de courant (30) circule dans l'alimentation réceptrice de courant (20).

3. Dispositif de commande d'un laser selon la revendication 1 ou la revendication 2, dans lequel le circuit de commutation (40) est un circuit de commutation différentiel ayant une paire de transistors NPN reliée en une configuration de paire différentielle.

4. Dispositif de commande d'un laser selon l'une quelconque des revendications précédentes, dans lequel l'alimentation génératrice de courant (30) et l'alimentation réceptrice de courant (20) comprennent un circuit à miroir de courant.

5. Unité de disque optique comprenant un laser (50) pour émettre un faisceau laser sur un disque optique, une alimentation génératrice de courant (30) pour délivrer un courant constant Ia, une alimentation réceptrice de courant (20) pour recevoir un courant constant Ib et un circuit de commutation (40) pour former sélectivement en réponse à un signal d'écriture soit un trajet de courant par l'intermédiaire duquel un courant constant Is provenant de l'alimentation génératrice de courant (30) circule principalement dans le laser (50), soit un trajet de courant par l'intermédiaire duquel le courant constant Ia provenant de l'alimentation génératrice de courant (30) circule principalement dans l'alimentation réceptrice de courant (20).
